# EUROPÄISCHE PATENTSCHRIFT

(11) **EP 0 821 480 B1**
(45) Veröffentlichungstag und Bekanntmachung des Hinweises auf die Patenterteilung: **24.09.2003**
(21) Anmeldenummer: 97112881.4
(22) Anmeldetag: 25.07.1997
(51) Int. Cl.: H03G 5/22

(54) **Einrichtung zum Verändern der Eckfrequenz eines Tiefpassfilters**
Device for modification of the cut-off frequency of a lowpass filter
Dispositif de modification de fréquence de coupure d'un filtre pass-bas

(30) Priorität: 26.07.1996 DE 19630405
(43) Veröffentlichungstag der Anmeldung: 28.01.1998
(73) Patentinhaber: SGS-THOMSON MICROELECTRONICS GMBH, 85630 Grasbrunn (DE)
(72) Erfinder: Kirchlechner, Peter, 83104 Hohenthann (DE); Schambacher, Jörg, 81667 München (DE); Lübbe, Jürgen, 83553 Jacobneuharting (DE)
(74) Vertreter: Hirsch, Peter, Dipl.-Ing.

(56) Entgegenhaltungen:
- US-A- 4 368 355
- US-A- 5 202 925
- PATENT ABSTRACTS OF JAPAN vol. 014, no. 108 (E-0896), 27. Februar 1990 (1990-02-27) & JP 01 309507 A (JAPAN RADIO CO LTD), 13. Dezember 1989 (1989-12-13)
- PATENT ABSTRACTS OF JAPAN vol. 015, no. 343 (E-1106), 30. August 1991 (1991-08-30) & JP 03 131117 A (FUJITSU TEN LTD), 4. Juni 1991 (1991-06-04)

## Beschreibung

Die Erfindung betrifft eine Einrichtung zum Verändern der Eckfrequenz eines Tiefpaßfilters im Signalweg eines Audiosignals in einem Audiogerät, abhängig von dem Spannungspegel eines Empfangsfeldstärkesignals.

Bei modernen Audiogeräten, insbesondere bei für den Einbau in Kraftfahrzeuge bestimmten Audiogeräten ist man bestrebt, möglichst viele Elemente des Geräts als integrierte Schaltung auszubilden, um einen billigen und kompakten Aufbau des Geräts bei gleichzeitig hoher Leistungsfähigkeit zu erreichen. Audiogeräte für Kraftfahrzeuge bestehen im einfachsten Fall nur aus einem Radio; modernere Geräte besitzen zusätzlich ein Kassettenteil. In jüngerer Zeit entwickelte Geräte enthalten zusätzlich zu dem Radio noch ein CD-Gerät.

Die von dem Tunerteil des Radios, von der Kassette oder von dem CD-Gerät kommenden Signale werden bei modernen Audiosignalprozessoren mit Hilfe einer einzigen integrierten Schaltung weiterverarbeitet, um der Leistungs-Endstufe zugeführt zu werden. Ein solcher Audiosignalprozessor enthält einen AM/FM-Stereodecoderabschnitt, Filter zum selektiven Dämpfen hoher, mittlerer und niedriger Frequenzen, ein Umschaltteil zum Umschalten auf Monobetrieb, falls die Empfangsfeldstärke für Stereobetrieb zu gering ist, und weitere Schaltungsteile. Gesteuert werden die einzelnen Elemente des Audioprozessors weitestgehend digital.

Bei der vorliegenden Erfindung geht es um eine auch als "high cut" bezeichnete Einrichtung zum Verändern der Eckfrequenz eines Tiefpaßfilters in Abhängigkeit der Empfangsfeldstärke. Bei zu geringer Empfangsfeldstärke ist der Störanteil höherfrequenter Signale relativ hoch, und indem man die Eckfrequenz des im Signalweg des Audiosignals liegenden Tiefpaßfilters in Richtung niedrigerer Frequenzen verschiebt, werden die höherfrequenten, stark mit Rauschen behafteten Signalanteile stärker gedämpft.

Der Amplitudengang des vom Sender gelieferten Signals ist nicht im gesamten Frequenzbereich konstant, sondern nur bis zu einer Frequenz von 3 kHz. Oberhalb dieser Frequenz steigt der Amplitudengang linear an. Von dem hier in Rede stehenden Tiefpaßfilter im Audiosignalprozessor wird diese Anhebung höherfrequenter Signalanteile (Emphasis) aufgehoben. Das Tiefpaßfilter besitzt eine Eckfrequenz, die im Normalfall bei 3 KHz liegt. Hierdurch wird die Anhebung der höherfrequenten Signalanteile auf der Seite des Senders durch die im Tiefpaß erfolgende Höhenabsenkung (Deemphasis) aufgehoben.

Als Zusatzfunktion läßt sich bei diesem Tiefpaßfilter die Frequenz noch weiter in den Bereich zwischen 1 und 3 kHz verschieben, abhängig von der Empfangsfeldstärke.

Wird nun ein Audiosignalprozessor in Form einer integrierten Schaltung hergestellt, so ist ein Stift (pin) des Chips als Eingang für das Empfangsfeldstärkesignal vorgesehen. Bei der Herstellung des Audiogeräts muß eine Kalibrierung vorgenommen werden, um die gewünschte Abhängigkeit der Eckfrequenz-Verschiebung von dem Pegel des Empfangsfeldstärkesignals zu erreichen. Bislang wurden zu diesem Zweck chipexterne Bauelemente (Widerstände) verwendet. Das Einstellen dieser Bauelemente erfordert einigen Aufwand. Darüberhinaus stellen die externen Bauelemente sowie deren Montage einen zusätzlichen Kostenfaktor dar, und auch die Zuverlässigkeit wird durch zahlreiche externe Bauelemente abträglich beeinflußt. Schließlich ist auch für jeden Kanal ein Stift an dem Chip erforderlich, um die externen Bauelemente mit dem im Chip ausgebildeten Tiefpaßfilter zu verbinden.

Der Erfindung liegt die Aufgabe zugrunde, eine Einrichtung zum Verändern der Eckfrequenz eines Tiefpaßfilters im Signalweg eines Audiosignals anzugeben, welche sich grundsätzlich vollständig als integrierte Schaltung ausbilden läßt.

Gelöst wird diese Aufgabe bei einer Einrichtung der eingangs genannten Art durch folgende Merkmale:
a) das Tiefpaßfilter weist eine Anzahl von Bauelementen auf, von denen jedes die Eckfrequenz mitbestimmt und die jeweils getrennt von einem zugehörigen Signal zu- oder abschaltbar sind; und
b) das Feldstärkesignal wird auf einen Analog/Digital-Wandler gegeben, dessen digitales Ausgangssignal den Bauelementen zugeführt wird, um diese abhängig vom logischen Pegel jeder Ziffernstelle des digitalen Ausgangssignals zu- oder abzuschalten.

Das Empfangsfeldstärkesignal wird extern gewonnen und einem Stift der integrierten Schaltung zugeführt. Der Analog-Digital-Wandler setzt das Feldstärkensignal in einen entsprechenden Digitalwert um. Wenn z.B. das digitale Signal insgesamt vier Ziffernstellen besitzt, können mit dem digitalen Signal sechzehn verschiedene Werte dargestellt werden, und dementsprechend läßt sich die Eckfrequenz auf einen von sechzehn verschiedenen Werten einstellen.

Bei den zu- und abschaltbaren Bauelementen des Tiefpaßfilters handelt es sich insbesondere um Kondensatoren, deren Kapazitätswerte auf die Wertigkeit der Ziffernstelle des digitalen Signals abgestimmt sind. Bei vier Ziffernstellen des digitalen Signals enthält das Tiefpaßfilter also vier zu- und abschaltbare Kondensatoren mit Kapazitätswerten von C; C/2; C/4 und C/8 in Parallelschaltung. Je nachdem, welche dieser Kondensatoren von der betreffenden Ziffernstelle des digitalen Signals aktiviert werden, wird die Kapazität der Parallelschaltung der Kondensatoren auf einen von sechzehn verschiedenen möglichen Werten eingestellt, so daß sie einen Wert zwischen 0 und ca. 2C aufweist und zusammen mit einem nicht-geschalteten, festen Kondensator eine mögliche Gesamtkapazität zwischen C und ca. 3C ergibt.

Bei der Auslegung der integrierten Schaltung steht natürlich noch nicht fest, welcher Pegel des Feldstärkesignals der obersten Eckfrequenz (z.B. 3 KHz) entspricht, und welcher Pegel des Feldstärkesignals der kleinstmöglichen Eckfrequenz des Tiefpaßfilters entspricht. Bei der Schaltung nach dem Stand der Technik ist die entsprechende Kalibrierung mit Hilfe der externen Bauelemente vorgenommen worden. Erfindungsgemäß ist hingegen vorgesehen, daß der Analog/Digital-Wandler zwei zusätzliche Eingänge für Einstellsignale aufweist, über die die Kennlinie des Wandlers einstellbar ist.

Mit dem Begriff "Kennlinie des Wandlers" ist die Abhängigkeit der digitalen Ausgangssignale des Wandlers vom Pegel des analogen Eingangssignals gemeint. Normalerweise liefert ein Analog/Digitalwandler ein digitales Signal mit dem Wert "null", wenn der Pegel am Eingang null beträgt, und es wird der größtmögliche Wert am Ausgang des Wandlers geliefert, wenn der Eingangspegel dem maximalen Nennpegel entspricht. Bei dem hier in Rede stehenden Analog/Digital-Wandler wird die Kennlinie so eingestellt, daß bei einem bestimmten, wählbaren Pegel des Feldstärkesignals der größtmögliche Wert des digitalen Ausgangssignals des Wandlers geliefert wird, der dann der größtmöglichen Eckfrequenz (3 KHz) des Tiefpaßfilters entspricht, während bei einer relativ niedrigen Spannung des Feldstärkesignals der kleinstmögliche Ausgangswert des digitalen Signals erzeugt wird. Diese beiden genannten Werte legen also fest, wie stark die Steuerung zur Einstellung der Eckfrequenz des Tiefpaßfilters auf eine Änderung des Feldstärkesignals anspricht. Erfindungsgemäß ist hierzu vorgesehen, daß den zusätzlichen Eingängen des Wandlers zwei Analogspannungen zugeführt werden, von denen die eine den größten und die andere den kleinsten möglichen Wert des digitalen Signals festlegt und damit bestimmt, bei welchem Pegel des Feldstärkesignals eine Verringerung der Eckfrequenz beginnt, bzw. bis zu welchem Pegel des Feldstärkesignals diese Verringerung möglich ist.

Ist das Feldstärkesignal größer als die erste Analogspannung, erfolgt keine Veränderung der Eckfrequenz des Tiefpaßfilters oberhalb von z.B. 3 KHz; ist das Feldstärkesignal niedriger als die zweite Analogspannung, so wird die Eckfrequenz nicht noch weiter nach unten verschoben, sondern bleibt auf dem niedrigsten Wert (z.B. 1 kHz).

Damit beim Hersteller des Audiogeräts, der den als integrierte Schaltung ausgebildeten Audioprozessor in sein Gerät einbaut, ein leichtes Kalibrieren des Tiefpaßfilters möglich ist, sieht die Erfindung vor, daß die zwei Analogspannungen, die zusätzlich an den Analog/Digitalwandler gegeben werden, aus voreinstellbaren Register-Inhalten gebildet werden. Die in dem Chip vorgesehene digitale Steuerung enthält Eingänge, über die z.B. die Einstellung von Lautstärke, Höhen, Bässen, Balance und dgl. erfolgt. Über solche Eingänge läßt sich der Inhalt jedes der beiden genannten Register und damit die "Kennlinie" des Wandlers einstellen.

Im folgenden wird ein Ausführungsbeispiel anhand der Zeichnungen näher erläutert. Es zeigen:
- Figur 1: ein vereinfachtes Blockschaltbild einer Ausführungsform einer erfindungsgemäßen Einrichtung zum Verändern der Eckfrequenz eines Tiefpaßfilters;
- Figuren 2a - 2c: den Frequenzgang eines im Sender erzeugten Signals, des empfängerseitigen Tiefpaßfilters gemäß der Erfindung bzw. des am Ausgang des Tiefpaßfilters erhaltenen Signals;
- Figur 3: eine Ausführungsform des als integrierte Schaltung ausgebildeten Tiefpaßfilters gemäß Figur 1;
- Figur 4: ein Ersatzschaltbild für die Schaltung nach Figur 3; und
- Figur 5: die Abhängigkeit der Eckfrequenz des Tiefpaßfilters von der Empfangsfeldstärke.

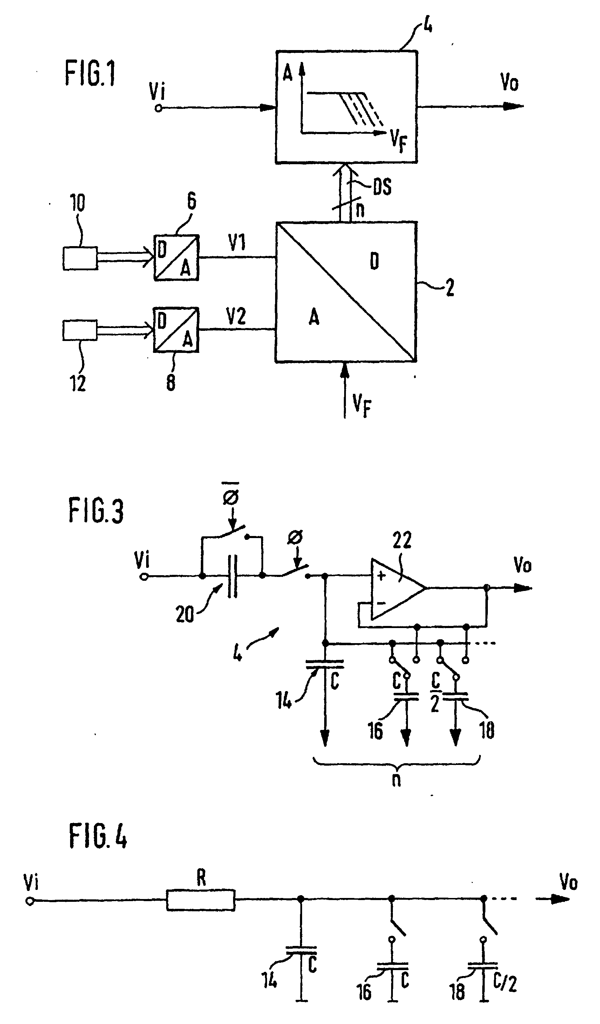

Die Schaltung nach Figur 1 erhält einen Analog/Digital-Wandler 2, der ebenso wie sämtliche übrigen in den Zeichnungen dargestellten Bauteile Bestandteil einer integrierten Schaltung ist. Der Analog/Digital-Wandler 2 empfängt an dem Analogsignaleingang ein Empfangsfeldstärkesignal in Form eines Spannungssignals V_{F} und setzt dieses Signal in ein digitales Signal DS um, welches ein vierstelliges Signal ist, mit dem sich folglich sechzehn unterschiedliche Werte darstellen lassen.

Ein Tiefpaßfilter 4 empfängt eingangsseitig von einem hier nicht dargestellten Stereodecoder ein demoduliertes Signal für den linken oder den rechten Kanal. Tatsächlich ist in dem Audioprozessor das in Figur 1 dargestellte Tiefpaßfilter 4 doppelt vorhanden, beide empfangen das digitale Ausgangssignal DS von dem Analog/Digital-Wandler 2.

Bei gutem Empfang ist die Empfangsfeldstärke hoch, dementsprechend hat das Signal V_{F} einen hohen Pegel. Das dementsprechend "hohe" Signal DS bewirkt in dem Tiefpaßfilter, daß die Eckfrequenz auf ihren höchsten Wert eingestellt ist.

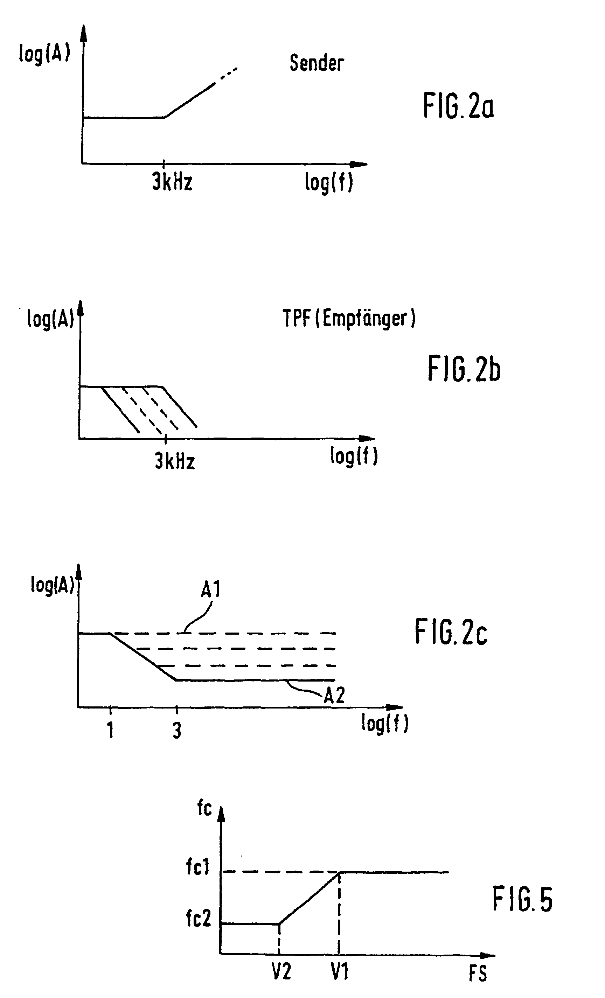

In Figur 5 ist die Abhängigkeit der Eckfrequenz fc von der Feldstärke FS dargestellt. Die Eckfrequenz fc1 bei relativ hohen Feldstärken, wenn das Signal V_{F} gleich oder größer V1 ist, beträgt 3KHz. Bei Feldstärken, die ein Signal V_{F} unterhalb von V1 liefern, wird die Eckfrequenz des Tiefpaßfilters gesenkt. Dieses Absenken der Eckfrequenz geht bis zu einer Untergrenze V2. Bei Feldstärken, die ein Feldstärkensignal V_{F} unterhalb von V2 liefern, bleibt die untere Eckfrequenz fc2 unverändert.

Zur Veranschaulichung sind in Figur 2 in doppelt logarithmischer Darstellung die Amplitudengänge des senderseitigen Signals, des Tiefpaßfilters im Empfänger bzw. des durch das Tiefpaßfilter gelieferten Signals dargestellt.

Wie eingangs erläutert, liefert der Sender ein Signal mit einer Emphase von Signalkomponenten oberhalb von 3 KHz (Figur 2a). Dem entspricht die oberste Eckfrequenz des im Empfänger befindlichen Tiefpaßfilters. Das Ausgangssignal des Filters hat also bei gutem Empfang den in Figur 2c mit A1 bezeichneten Amplitudengang.

Bei nichtoptimalem Empfang sinkt der Pegel des Feldstärkensignals V_{F}. Um das störende hochfrequente Rauschen zu unterdrücken, wird die Eckfrequenz des Tiefpaßfilters nach unten verschoben, so daß die höherfrequenten Signalanteile stärker gedämpft werden. Diese Möglichkeit der Verschiebung der Eckfrequenz ist in Figur 2B dargestellt. Die tiefste Eckfrequenz ist in Figur 2b durch eine ausgezogene Kennlinie dargestellt, diese Kennlinie entspricht der in Figur 2c dargestellten Linie A2, wonach unterhalb von 1 kHz keine Absenkung erfolgt, die Dämpfung oberhalb von 3 kHz konstant und am größten ist und die Dämpfung zwischen 1 und 3 kHz linear zunimmt.

Die in Figur 5 dargestellte Kennlinie, speziell der der oberen Eckfrequenz entsprechende Wert V1 und der der kleinstmöglichen Eckfrequenz entsprechende Wert V2 werden bei der in Figur 1 gezeigten Schaltung dem Analog/Digital-Wandler 2 von zwei Registern 10 und 12 über zugehörige Digital/Analog-Wandler 6 bzw. 8 zugeführt. In die Register 10 und 12 lassen sich vom Audiogerät-Hersteller, der den als Chip ausgebildeten Audioprozessor in das Gerät einbaut, digitale Werte eingeben, und diese digitalen Werte werden dann von den Wandlern 6 bzw. 8 in zwei Analogspannungen V1 und V2 umgesetzt, durch die festgelegt wird, in welchem Bereich eine Umsetzung der analogen Spannung V_{F} in ein digitales Signal DS erfolgt. Hat die Spannung V_{F} einen Wert unterhalb von V2, so liefert der Wandler 2 bspw. immer als digitales Ausgangssignal den Wert "null" (z.B. "0000"). Ist der Wert der Analogspannung V_{F} größer als V1, so liefert der Wandler 2 stets den größtmöglichen digitalen Wert, also im Fall von vierstelligen digitalen Signalen (n = 4) der Wert fünfzehn (1111).

Liegt der Wert des Signals V_{F} zwischen V1 und V2, erfolgt in linearer Abhängigkeit eine Umsetzung des Analogsignals in ein entsprechendes digitales Signal.

Dieses digitale Signal DS wird einem Einstelleingang des Tiefpaßfilters 4 zugeführt.

Bevor die Schaltung nach Figur 3 näher erläutert wird, soll ein "Ersatzschaltbild" des Tiefpaßfilters gemäß Figur 4 erläutert werden. Das in Figur 4 dargestellte Tiefpaßfilter besitzt einen Widerstand R, einen festen, nicht-geschalteten Kondensator 14 und zuschaltbare Kondensatoren 16, 18. Dieses RC-Glied kann so eingestellt werden, daß die Gesamtkapazität zwischen C (bei nicht zugeschalteten Kondensatoren 16, 18...) und knapp 3C (wenn alle Kondensatoren zugeschaltet sind) liegt.

Die in Figur 3 dargestellte Schaltung ist vollständig integriert ausgebildet. Einer Reihe von parallel geschalteten Kondensatoren, von denen drei Kondensatoren 14, 16 und 18 dargestellt sind, wird das digitale Signal DS zugeführt, so daß abhängig davon, ob die betreffende Ziffernstelle des digitalen Signals DS den logischen Pegel "1" oder "0" hat, der zugehörige Kondensator zugeschaltet oder abgeschaltet wird. Die Abstufung der Kapazitätswerte der Kondensatoren entspricht der Wertigkeit der betreffenden Ziffernstelle des digitalen Signals DS. Das Eingangssignal Vi wird über einen zur Nachbildung eines ohmschen Widerstands dienenden geschalteten Kondensators 20 dem nicht-invertierenden Eingang eines Operationsverstärkers 22 zugeführt, der als Spannungsfolger geschaltet ist.

Werden die beiden Kondensatoren 16, 18 in Fig. 3 abgeschaltet, liegen sie am Ausgang Vo und besitzen folglich die jeweilige Ausgangsspannung.

Aus der obigen Erläuterung sind Aufbau und Wirkungsweise der Schaltung ersichtlich. Man erkennt insbesondere, daß keine externen Schaltungselemente benutzt werden, um das Tiefpaßfilter zu justieren. Die einzige von außen über einen separaten Stift an dem Chip zugeführte Größe ist das Empfangsfeldstärkesignal V_{F}.

## Patentansprüche

1. Einrichtung zum Verändern der Eckfrequenz eines Tiefpaßfilters (4) im Signalweg eines Audiosignals (Vi) in einem Audiogerät, abhängig von dem Spannungspegel eines Empfangsfeldstärkesignals (V_{F}),
umfassend folgende Merkmale:
a) das Tiefpaßfilter (4) weist eine Anzahl (n) von Bauelementen (14-18) auf, von denen jedes die Eckfrequenz mitbestimmt, und die jeweils getrennt von einem zugehörigen Signal zu- oder abschaltbar sind; und
b) Mittel mit denen das Feldstärkensignal auf einen Analog/Digital-Wandler (2) gegeben wird, dessen digitales Ausgangssignal (DS) den Bauelementen (14-18) zugeführt wird, um diese abhängig vom logischen Pegel jeder Ziffernstelle des digitalen Ausgangssignals (DS) zu- oder abzuschalten,
**dadurch gekennzeichnet, daß** der Analog/Digital-Wandler (2) zwei zusätzliche Eingänge für Einstellsignale (V1, V2) aufweist, über die die Kennlinie des Wandlers (2) einstellbar ist, daß den zusätzlichen Eingängen zwei Analogspannungen (V1, V2) zugeführt werden, von denen die eine den Pegel dur Feldstärke für den größten und die andere den Pegel dur Feldstärke für den kleinsten möglichen Wert des digitalen Signals (DS) festlegt und damit bestimmt, bei welchem Pegel des Feldstärkesignals (V_{F}) eine Verringerung der Eckfrequenz (fc) beginnt, bzw. bis zu welchem Pegel des Feldstärkesignals (V_{F}) diese Verringerung möglich ist.

2. Einrichtung nach Anspruch 1,
**dadurch gekennzeichnet, daß** die zu-und abschaltbaren Bauelemente Kondensatoren sind, deren Kapazitätswerte (C; C/2; C/4 ...) auf die Wertigkeit der Ziffernstellen des digitalen Signals abgestimmt sind.

3. Einrichtung nach Anspruch 1 oder 2,
**dadurch gekennzeichnet, daß** die zwei Analogspannungen mit Hilfe von Digital/Analog-Wandlern aus voreinstellbaren Register-Inhalten gebildet werden.

4. Einrichtung nach einem der vorhergehenden Ansprüche,
**dadurch gekennzeichnet, daß** sie vollständig als integrierte Schaltung ausgebildet ist.

## Claims

1. A device for varying the cutoff frequency of a low-pass filter (4) in the signal path of an audio signal (Vi) in an audio device, in accordance with the voltage level of a received field strength signal (V_{F}), including the following features:
a) the low-pass filter (4) has a number (n) of components (14 to 18) each of which codetermines the cutoff frequency and which are each separately connectable or disconnectable by a corresponding signal; and
b) means for feeding the field strength signal to an analog-to-digital converter (2) whose digital output signal (DS) is supplied to the components (14 to 18) to connect or disconnect them in accordance with the logic level of each digit place of the digital output signal (DS),
**characterized in that** the analog-to-digital converter (2) has two additional inputs for adjusting signals (V1, V2) for adjusting the characteristic of the converter (2),
the additional inputs are supplied two analog voltages (V1, V2) one of which fixes the level of field strength for the greatest, and the other the level of field strength for the smallest, possible value of the digital signal (DS) and thus determines at which level of the field strength signal (V_{F}) a reduction in cutoff frequency (fc) begins, or up to which level of the field strength signal (V_{F}) this reduction is possible.

2. The device of claim 1, **characterized in that** the connectable and disconnectable components are capacitors whose capacitance values (C; C/2; C/4...) are coordinated with the weight of the digit places of the digital signal.

3. The device of claim 1 or 2, **characterized in that** the two analog voltages are formed from presettable register contents with the aid of digital-to-anaiog converters.

4. The device of any of the above claims, **characterized in that** it is formed completely as an integrated circuit.

## Revendications

1. Dispositif de modification de la fréquence de coupure d'un filtre passe-bas (4) dans le trajet des signaux d'un signal audio (Vi) dans une unité audio en fonction du niveau de tension d'un signal d'intensité de champ de réception (V_{F}), ayant les caractéristiques suivantes :
a) le filtre passe-bas (4) comprend un nombre (n) de composants (14-18), dont chacun participe à la définition de la fréquence de coupure et qui peuvent être mis respectivement séparément en circuit ou hors circuit par un signal correspondant et
b) des moyens permettent d'appliquer le signal d'intensité de champ sur un convertisseur analogique/digital (2), dont le signal digital de sortie (DS) est amené aux composants (14-18) pour, en fonction du niveau logique de chaque position de chiffre du signal digital de sortie (DS), les mettre en service ou hors service,
**caractérisé en ce que** le convertisseur analogique/digital (2) comprend deux entrées supplémentaires pour des signaux de réglage (V1, V2) permettant de régler la courbe caractéristique du convertisseur (2) et **en ce qu'**aux entrées supplémentaires sont amenées deux tensions analogiques (V1, V2), dont l'une définit le niveau de l'intensité de champ pour la valeur la plus importante possible et dont l'autre définit le niveau de l'intensité de champ pour la valeur la plus faible possible du signal digital (DS) en définissant ainsi à quel niveau du signal d'intensité de champ (V_{F}) commence une réduction de la fréquence de coupure (fc) ou jusqu'à quel niveau du signal d'intensité de champ (V_{F}) cette diminution est possible.

2. Dispositif selon la revendication 1, **caractérisé en ce que** les composants pouvant être mis en service ou hors service sont des condensateurs dont les valeurs de capacité (C; C/2; C/4...) sont ajustées à la valence des positions de chiffre du signal digital.

3. Dispositif selon la revendication 1 ou 2, **caractérisé en ce que** les deux tensions analogiques sont formées à l'aide de convertisseurs digitaux/analogiques à partir de contenus de registres pouvant être réglés par avance.

4. Dispositif selon l'une quelconque des revendications précédentes,
**caractérisé en ce qu'**il est entièrement réalisé en tant que circuit intégré.
